# EUROPEAN PATENT SPECIFICATION

(11) **EP 2 718 974 B1**
(45) Date of publication and mention of the grant of the patent: **09.10.2019**
(21) Application number: 12797523.3
(22) Date of filing: 06.06.2012
(51) Int. Cl.: H01L 27/146, H01L 27/14, H01L 51/52, H01L 51/44, H01L 27/28, C09K 11/56

(54) **INFRARED IMAGING DEVICE INTEGRATING AN IR UP-CONVERSION DEVICE WITH A CMOS IMAGE SENSOR**
INFRAROTABBILDUNGSVORRICHTUNG MIT IR-AUFWÄRTSWANDLER UND CMOS-BILDSENSOR
DISPOSITIF D'IMAGERIE INFRAROUGE COMPRENANT UN DISPOSITIF DE CONVERSION ASCENDANTE À INFRAROUGE ET UN CAPTEUR D'IMAGE CMOS

(30) Priority: 06.06.2011 US 201161493691 P
(43) Date of publication of application: 16.04.2014
(73) Proprietor: University of Florida Research Foundation, Inc., Gainesville, FL 32611 (US); Nanoholdings, LLC, Rowayton, CT 06853 (US)
(72) Inventor: SO, Franky, Gainesville, FL 32653 (US); KIM, Do, Young, Gainesville, FL 32653 (US); PRADHAN, Bhabendra, K., Marietta, GA 30066 (US)
(74) Representative: Potter Clarkson
(86) International application number: PCT/US2012/040980
(87) International publication number: WO 2012/170456

(56) References cited:
- WO-A2-2011/066396
- WO-A2-2011/066396
- JP-A- 2003 083 809
- US-A- 4 885 211
- US-A1- 2005 161 703
- US-A1- 2007 216 985
- CHEN J ET AL: "Near-infrared optical upconverter based on i-In0.53Ga0.47As/C60 photovoltaic heterojunction", ELECTRONIC LETTERS, THE INSTITUTION OF ENGINEERING AND TECHNOLOGY, vol. 45, no. 14, 2 July 2009 (2009-07-02), pages 753-755, XP006033469, ISSN: 1350-911X, DOI: 10.1049/EL:20093592
- JUE WANG ET AL: "Correlation between mechanical stress and optical property of SiO2/Ta2O5 multilayer UV narrow band filter deposited by plasma ion-assisted deposition", PROCEEDINGS OF SPIE, vol. 5870, 18 August 2005 (2005-08-18), pages 58700E-58700E-9, XP055137261, ISSN: 0277-786X, DOI: 10.1117/12.613285
- KIM, D. Y. ET AL.: 'Organic infrared upconversion device' ADVANCED MATERIALS vol. 22, no. IS.20, 25 May 2010, pages 2260 - 2263, XP055064381
- CHEN, JUN ET AL.: 'Near-Infrared Inorganic/Organic Optical Upconverter with a n External Power Efficiency of >100%' ADVANCED MATERIALS vol. 22, no. IS.43, 16 November 2010, pages 4900 - 4904, XP055064383

## Description

### BACKGROUND OF INVENTION

Recently, light up-conversion devices have attracted a great deal of research interest because of their potential applications in night vision, range finding, and security, as well as semiconductor wafer inspections. Early near infrared (NIR) up-conversion devices were mostly based on the heterojunction structure of inorganic semiconductors, where a pbotodetecting and a luminescent section are in series. The up-conversion devices are mainly distinguished by the method of photodetection. Up-conversion efficiencies of devices are typically very low. For example, one NIR-to-visible light up-conversion device that integrates a light-emitting diode (LED) with a semiconductor based photodetector exhibits a maximum external conversion efficiency of only 0.048 (4.8%) W/W. A hybrid organic/inorganic up-conversion device, where an InGaAs/InP photodetector is coupled to an organic light-emitting diode (OLED), exhibits an external conversion efficiency of 0.7% W/W.

Currently, inorganic and hybrid up-conversion devices are expensive to fabricate and the processes used for fabricating these devices are not compatible with large area applications. Efforts are being made to achieve low cost up-conversion devices that have higher conversion efficiencies, although none has been identified that allow sufficient efficiency for a practical up-conversion device. For some applications, such as night vision devices, up-conversion devices having an infrared (IR) sensitizing layer with a broad absorption spectrum is very desirable. Additionally, the amplification of the signal is desirable, without having the need for moonlight or any additional illuminating source.

WO 2011/066396 discloses a method and apparatus for sensing infrared radiation.

### BRIEF SUMMARY

Embodiments of the invention are directed to imaging devices comprising a transparent infrared (IR) to visible up-conversion device that has a multilayer stack structure and a CMOS image sensor (CIS). The stacked layer structure includes a transparent anode, at least one hole blocking layer, an IR sensitizing layer, at least one hole transport layer (HTL), a light emitting layer (LED), at least one electron transport layer (ETL), and a transparent cathode. Furthermore, the IR sensitizing layer comprises polydispersed quantum dots (QDs).

Additionally the up-conversion device can include an antireflective layer and/or an IR pass visible blocking layer. The multilayer stack can be formed on a substrate. The substrate can be the CIS. The substrate can be a support layer that is rigid and the up-conversion device is coupled to the CIS by a mechanical fastener or an adhesive, or the support layer can be flexible and the up-conversion device is laminated to the CIS to form the imaging device.

### BRIEF DESCRIPTION OF DRAWINGS

Figure 1 is a schematic cross-section of an infrared-to-visible up-conversion device to be employed with a CMOS image sensor (CIS) according to an embodiment of the invention.
Figure 2 is an energy band diagram of the up-conversion device of Figure 1.
Figure 3 shows a composite of absorbance spectra for various diameter PbSe QDs that can be combined as the infrared (IR) sensitizing layer of an imaging device, where the insert shows the absorbance spectrum for a 50 nm thick film of monodispersed PbSe and a TEM image of the film.
Figure 4 shows a composite plot of conversion efficiencies for different biases for a transparent up-conversion device as illustrated in the insert under near infrared (NIR) illumination that can be employed in an embodiment of the invention.
Figure 5 illustrates the construction of an imaging device, according to an embodiment of the invention, where a ridged up-conversion device is coupled to a CIS.
Figure 6 illustrates the construction of an imaging device, according to an embodiment of the invention, where a flexible up-conversion device is laminated to a CIS.
Figure 7 illustrates an imaging device, according to an embodiment of the invention, where the up-conversion device is formed directly on a CIS substrate.

### DETAILED DISCLOSURE

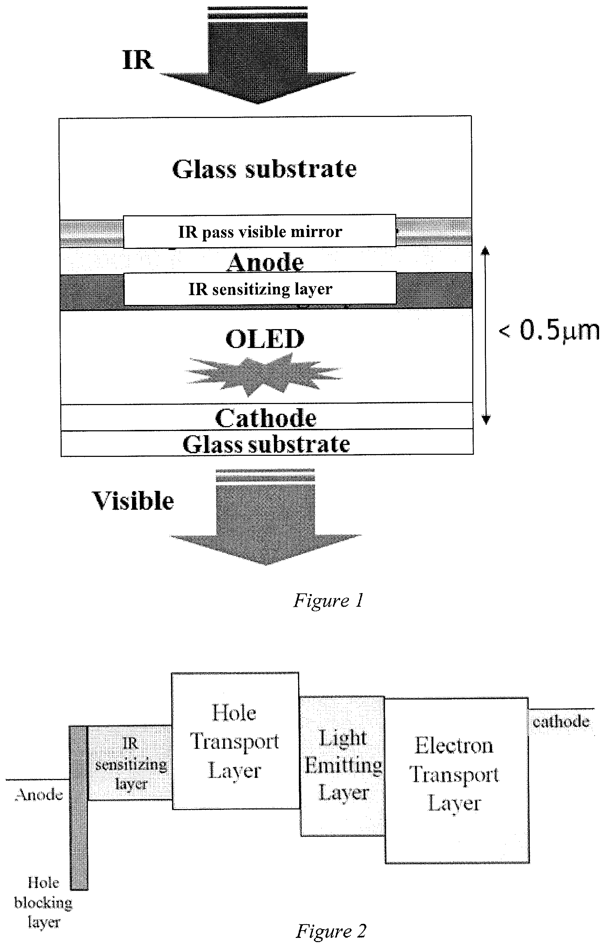

Embodiments of the invention are directed to an up-conversion device coupling an infrared (IR) sensitizing layer with a visible light emitting layer that is formed on or coupled to a CMOS image sensor (CIS). Figure 1 is a schematic diagram of an up-conversion device comprising a multilayer stack, including an IR sensitizing layer and an organic light emitting layer (LED), which generates visible light, sandwiched between a cathode and an anode. Figure 2 shows the band diagram for an up-conversion device according to an embodiment of the invention, where a hole blocking layer is inserted between the IR sensitizing layer and the anode to reduce dark current in the up-conversion device.

In one embodiment of the invention, the up-conversion device uses a film of polydispersed PbSe quantum dots (QDs) as the IR sensitizing layer, where the various sized QDs absorb IR radiation, or IR as used herein, with various absorption maxima over a range of wavelengths from less than 1µm to about 2 µm, to provide a broad spectrum sensitivity of the IR sensitizing layer.

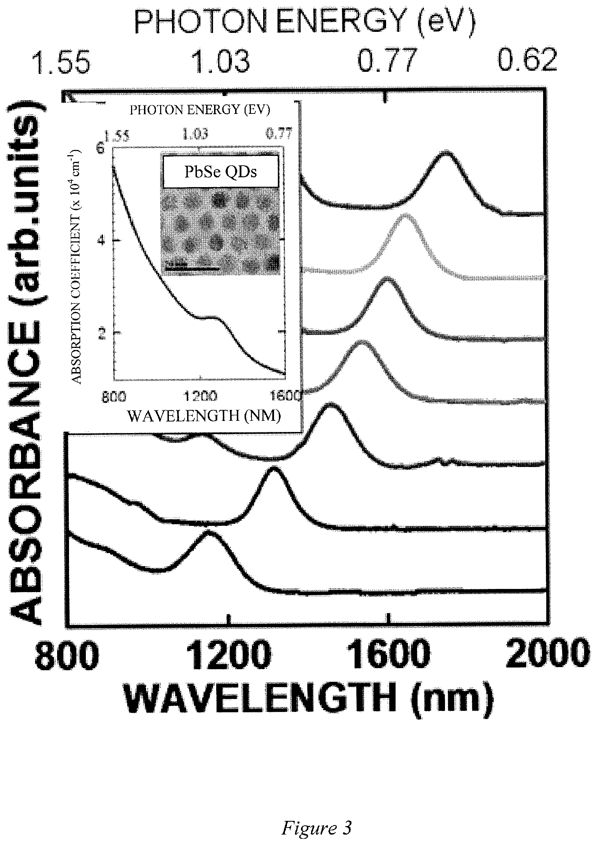

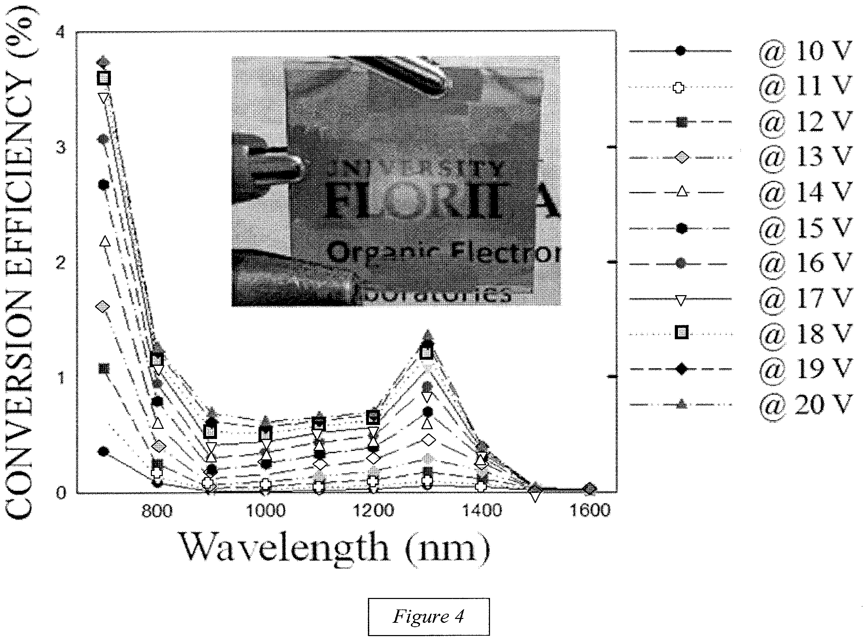

The varying absorbance maxima for different sized QDs are illustrated in the composite spectra shown in Figure 3. The insert of Figure 3 shows the absorbance spectrum for a 50 nm thick film of monodispersed PbSe QDs having an absorbance peak at 1.3 µm. However, as shown in Figure 4, the photon-to-photon conversion efficiency, for an up-conversion device constructed with the monodispersed QDs shown in the insert of Figure 3, does not achieve an efficiency of more than a few percent for NIR irradiation, even at a relatively high bias of 20V. As the conversion efficiency is less than 10% over this range, reasonable detection of the IR signal can be accomplished by amplification of the IR input or the visible light output signal.

In embodiments of the invention, the output signal is optimized by coupling the up-conversion device to a CIS. The electrodes of the up-conversion device are transparent, such that entering IR radiation is transported to the IR sensitizing layer, and the entering light and the generated light can reach the surface of the CIS at the light exiting surface of the up-conversion device. CIS technology is mature and is widely used for capturing images for commercially available digital cameras. These CIS have pixels having at least one amplifier with the photodetector. By inclusion of the CIS with the up-conversion device, amplification of the IR generated image signal is achieved by coupling with the CIS, allowing the imaging device to be used for night vision applications, even when the IR irradiation source is of low intensity.

Figure 2 is a schematic energy band diagram of an up-conversion device having an IR sensitizing layer, which can be a broad absorbing sensitizing layer comprising polydispersed QDs, according to an embodiment of the invention. The HBL can be an organic HBL comprising, for example, 2,9-Dimethyl-4,7-diphenyl-1,10-phenanthroline (BCP) *p-bis*(triphenylsilyl)benzene (UGH2), 4,7-diphenyl-1,10-phenanthroline (BPhen), tris-(8-hydroxy quinoline) aluminum (Alq₃), 3,5'-N,N'-dicarbazole-benzene (mCP), C₆₀, or tris[3-(3-pyridyl)-mesityl]borane (3TPYMB). The hole blocking layer (HBL) can be an inorganic HBL comprising, for example, ZnO or TiO₂. The anode can be, but is not limited to: Indium tin oxide (ITO), indium zinc oxide (IZO), aluminum tin oxide (ATO), aluminum zinc oxide (AZO) or carbon nanotubes.

Materials that can be employed as hole transport layers (HTLs) include, but are not limited to: 1,1-bis[(di-4-tolylamino)phenyl]cyclohexane (TAPC), N,N'-diphenyl-N,N'(2-naphthyl)-(1,1'-phenyl)-4,4'-diamine (NPB), and N,N'-diphenyl-N,N'-di(m-tolyl) benzidine (TPD). Electroluminescent light emitting (LED) materials that can be employed include, but are not limited to: *tris*-(2-phenylpyidine) iridium, Ir(ppy)₃, poly-[2-methoxy, 5-(2'-ethylhexyloxy) phenylene vinylene] (MEH-PPV), *tris*-(8-hydroxy quinoline) aluminum (Alq₃), and iridium (III) *bis*-[(4,6-di-fluorophenyl)-pyridinate-N,C2']picolinate (FIrpic). Materials that can be employed as electron transport layers (ETLs) include, but are not limited to: tris[3-(3-pyridyl)-mesityl]borane (3TPYMB), 2,9-Dimethyl-4,7-diphenyl-1,10-phenanthroline (BCP), 4,7-diphenyl-1,10-phenanthroline (BPhen), and tris-(8-hydroxy quinoline) aluminum (Alq₃).

The cathode can be indium tin oxide (ITO), indium zinc oxide (IZO), aluminum tin oxide (ATO), aluminum zinc oxide (AZO), carbon nanotube, silver nanowire, or an Mg:Al layer. In one embodiment of the invention a stacked 10:1 Mg:Ag layer with a thickness of less than 20nm is used as a transparent electrode. In one embodiment of the invention, an anti-reflective layer is situated on the exterior surface of the transparent cathode. For example, an Alq₃ layer can be an anti-reflective layer that allows good transparency when the Alq₃ layer is less than about 100 nm in thickness. Alternately, the antireflective layer can be a metal oxide, such as MoO₃, of about 50 nm or less in thickness. In one embodiment of the invention, the visible light exit face comprises a 10:1 Mg:Al cathode layer of about 10 nm, and an Alq₃ layer of 50 nm is situated upon the cathode.

Those skilled in the art, having benefit of the current disclosure, can readily identify appropriate combinations of anodes, cathodes, LED materials, hole transport layers, HBLs, and electron transport layers by their relative work functions, HOMO and LUMO levels, layer compatibility, and the nature of any desired deposition methods used during their fabrication. In embodiments of the invention, the anode and the cathode are transparent and the multilayer stack can be formed on a transparent support that is rigid, such as glass, or is flexible, such as an organic polymer.

In one embodiment of the invention, the up-conversion device includes an IR pass visible blocking layer that is situated between a substrate and the anode. The IR pass visible blocking layer used in the up-conversion device can employ a multi dielectric stack layer. The IR pass visible blocking layer comprises a stack of dielectric films with alternating films having different refractive indices, one of high refractive index and the other of a significantly lower refractive index. An exemplary IR pass visible blocking layer is constructed of a composite of 2 to 80 alternating layers of Ta₂O₅ (RI = 2.1) and SiO₂ (RI = 1.45) that are 10 to 100 nm in thickness.

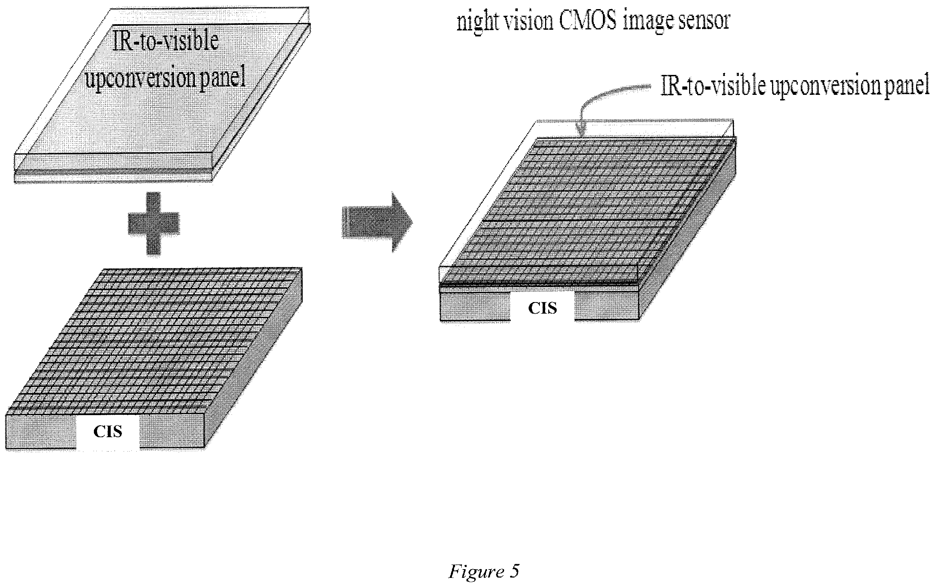

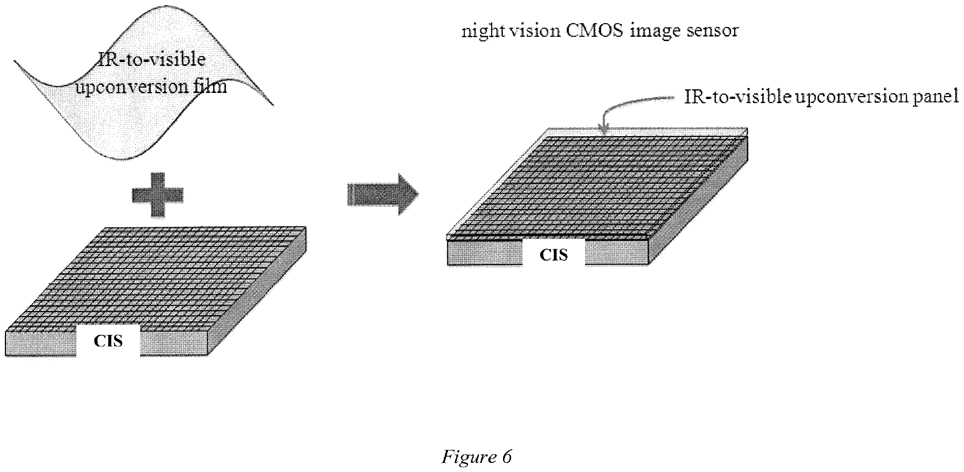

The coupling of a CIS to the up-conversion device to form the imaging device can be achieved in a variety of manners. In Figures 5 and 6, the up-conversion device is constructed independently of the CIS and the two devices are coupled by stacking the two devices, such that the visible light emitted by the light emitting layer activates the photodetector of pixels of the CIS and the resulting electronic signal is amplified by the amplifier in the pixel. The up-conversion device of Figure 5 comprises a pair of glass substrates and is positioned onto the CIS. The two rigid devices can be coupled, for example, by mechanical fasteners or an adhesive. In Figure 6, the up-conversion device is constructed as a transparent flexible film that is subsequently laminated to the CIS.

In some embodiments of the invention, the CIS is the image sensor and provides amplification without requiring filters for specific radiation frequency ranges or micro lenses to direct light to the photodetector of the pixels.

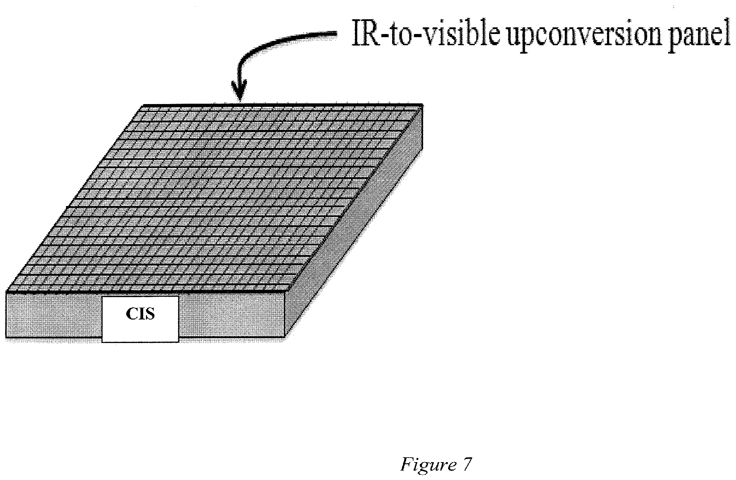

In another embodiment of the invention, as illustrated in Figure 7, the CIS is used as the substrate upon which the layers of the up-conversion device are constructed, resulting in a single module comprising the imaging device's up-conversion device and CIS.

## Claims

1. An imaging device, comprising a transparent IR up-conversion device, wherein the transparent IR up-conversion device is a multilayer stack comprising: an anode layer; a hole blocking layer; an IR sensitizing layer; a hole transport layer; a light emitting layer; an electron transport layer; and a cathode, **characterised in that** the IR sensitizing layer comprises polydispersed quantum dots (QDs) having various absorption maxima over a range of wavelengths from less than 1 µm to 2 µm and **in that** the imaging device further comprises a CMOS image sensor (CIS).

2. The imaging device of claim 1, wherein the anode comprises indium tin oxide (ITO), indium zinc oxide (IZO), aluminum tin oxide (ATO), aluminum zinc oxide (AZO), carbon nanotubes, or silver nanowires.

3. The imaging device of claim 1, wherein the hole blocking layer comprises TiO₂, ZnO, BCP, Bphen, 3TPYMB, or p-bis(triphenylsilyl)benzene (UGH2).

4. The imaging device of claim 1, wherein the IR sensitizing layer comprises PbSe QDs or PbS QDs.

5. The imaging device of claim 1, wherein the hole transport layer comprises 1,1-bis[(di-4-tolylamino)phenyl]cyclohexane (TAPC), N,N'-diphenyl-N,N'(2-naphthyl)-(1,1'-phenyl) -4,4'-diamine (NPB), or N,N'-diphenyl-N,N'-di(m-tolyl) benzidine (TPD).

6. The imaging device of claim 1, wherein the light emitting layer comprises *tris*-(2-phenylpyridine) iridium (Ir(ppy)₃), poly-[2-methoxy, 5-(2'-ethyl-hexyloxy) phenylene vinylene] (MEH-PPV), *tris*-(8-hydroxy quinoline) aluminum (Alq₃), or iridium (III) *bis*-[(4,6-difluorophenyl)-pyridinate-N,C2']picolinate (Flrpic).

7. The imaging device of claim 1, wherein the electron transport layer comprises tris[3-(3-pyridyl)-mesityl]borane (3TPYMB), 2,9-Dimethyl-4,7-diphenyl-1,10-phenanthroline (BCP), 4,7-diphenyl-1,10-phenanthroline (BPhen), or tris-(8-hydroxy quinoline) aluminum (Alq₃).

8. The imaging device of claim 1, wherein the cathode comprises indium tin oxide (ITO), indium zinc oxide (IZO), aluminum tin oxide (ATO), aluminum zinc oxide (AZO), carbon nanotube, silver nanowire, or Mg:Al.

9. The imaging device of claim 1, wherein the multilayer stack further comprises an anti-reflective layer on the cathode.

10. The imaging device of claim 9, wherein the anti-reflective layer comprises an Alq₃ layer having a thickness of less than 200 nm.

11. The imaging device of claim 1, wherein the multilayer stack further comprises an IR pass visible blocking layer situated on the anode.

12. The imaging device of claim 11, wherein the IR pass visible blocking layer comprises a plurality of alternating layers of materials having different refractive indexes.

13. The imaging device of claim 12, wherein the alternating layers comprise Ta₂O₅ and SiO₂ layers of 10 to 100 nm in thickness and the IR pass visible blocking layer comprises 2 to 80 layers.

14. The imaging device of claim 1, wherein the CIS is the substrate for the multilayer stack.

15. The imaging device of claim 1, wherein the multilayer stack further comprises a support layer.

16. The imaging device of claim 1, wherein the support layer is rigid and the up-conversion device is coupled to the CIS by a mechanical fastener or an adhesive.

17. The imaging device of claim 1, wherein the support layer is flexible and the up-conversion device is laminated to the CIS.

## Patentansprüche

1. Bilderzeugungsvorrichtung, umfassend eine transparente IR-Hochkonversionsvorrichtung, wobei die transparente IR-Hochkonversionsvorrichtung ein Mehrschichtstapel ist, umfassend:
eine Anodenschicht;
eine Lochblockierschicht;
eine IR-sensibilisierende Schicht;
eine Lochtransportschicht;
eine lichtemittierende Schicht;
eine Elektronentransportschicht; und
eine Kathode, **dadurch gekennzeichnet, dass** die IR-sensibilisierende Schicht polydisperse Quantenpunkte (*quantum dots,* QDs), die verschiedene Absorptionsmaxima über einen Wellenlängenbereich von weniger als 1 µm bis 2 µm aufweisen, umfasst, und dass die Bilderzeugungsvorrichtung ferner einen CMOS-Bildsensor ((*complementary metal oxide semiconductors,* CMOS) CMOS *image sensor,* CIS) umfasst.

2. Bilderzeugungsvorrichtung nach Anspruch 1, wobei die Anode Indiumzinnoxid (ITO), Indiumzinkoxid (IZO), Aluminiumzinnoxid (ATO), Aluminiumzinkoxid (AZO), Kohlenstoffnanoröhren oder Silbernanodrähten umfasst.

3. Bilderzeugungsvorrichtung nach Anspruch 1, wobei die Lochblockierschicht TiO₂, ZnO, BCP, Bphen, 3TPYMB oder p-Bis(triphenylsilyl)benzol (UGH2) umfasst.

4. Bilderzeugungsvorrichtung nach Anspruch 1, wobei die IR-sensibilisierende Schicht PbSe-QDs oder PbS-QDs umfasst.

5. Bilderzeugungsvorrichtung nach Anspruch 1, wobei die Lochtransportschicht 1,1-Bis[(di-4-tolylamino)phenyl]cyclohexan (TAPC), N,N'-Diphenyl-N,N'(2-naphthyl)-(1,1'-phenyl)-4,4'-Diamin (NPB) oder N,N'-Diphenyl-N,N'-di(m-tolyl)benzidin (TPD) umfasst.

6. Bilderzeugungsvorrichtung nach Anspruch 1, wobei die lichtemittierende Schicht *Tris-*(2-phenylpyridin)iridium (Ir(ppy)₃), Poly-[2-methoxy, 5-(2'-ethylhexyloxy)phenylenvinylen] (MEH-PPV), *Tris*-(8-Hydroxychinolin)aluminium (Alq₃) oder Iridium (III) *bis*-[(4,6-difluorphenyl)pyridinat-N,C2']picolinat (Flrpic) umfasst.

7. Bilderzeugungsvorrichtung nach Anspruch 1, wobei die Elektronentransportschicht Tris-[3-(3-pyridyl)-mesityl]boran (3TPYMB), 2,9-Dimethyl-4,7-diphenyl-1,10-phenanthrolin (BCP), 4,7-diphenyl-1,10-Phenanthrolin (BPhen) oder Tris-(8-hydroxychinolin)aluminium (Alq₃) umfasst.

8. Bilderzeugungsvorrichtung nach Anspruch 1, wobei die Kathode Indiumzinnoxid (ITO), Indiumzinkoxid (IZO), Aluminiumzinnoxid (ATO), Aluminiumzinkoxid (AZO), Kohlenstoffnanoröhrchen, Silbernanodraht oder Mg:Al umfasst.

9. Bilderzeugungsvorrichtung nach Anspruch 1, wobei der Mehrschichtstapel ferner eine Antireflexionsschicht auf der Kathode umfasst.

10. Bilderzeugungsvorrichtung nach Anspruch 9, wobei die Antireflexionsschicht eine Alq₃-Schicht mit einer Dicke von weniger als 200 nm umfasst.

11. Bilderzeugungsvorrichtung nach Anspruch 1, wobei der Mehrschichtstapel ferner eine IR-durchsichtige Blockierschicht umfasst, die auf der Anode angeordnet ist.

12. Bilderzeugungsvorrichtung nach Anspruch 11, wobei die IR-durchsichtige Blockierschicht mehrere alternierende Schichten von Materialien umfasst, die unterschiedliche Brechungsindizes aufweisen.

13. Bilderzeugungsvorrichtung nach Anspruch 12, wobei die alternierenden Schichten Ta₂O₅- und SiO₂-Schichten von 10 bis 100 nm Dicke umfassen und die IR-durchsichtige Blockierschicht 2 bis 80 Schichten umfasst.

14. Bilderzeugungsvorrichtung nach Anspruch 1, wobei der CIS das Substrat für den Mehrschichtstapel ist.

15. Bilderzeugungsvorrichtung nach Anspruch 1, wobei der Mehrschichtstapel ferner eine Trägerschicht umfasst.

16. Bilderzeugungsvorrichtung nach Anspruch 1, wobei die Trägerschicht starr ist und die Hochkonversionsvorrichtung durch ein mechanisches Befestigungsmittel oder einen Klebstoff mit dem CIS verbunden ist.

17. Bilderzeugungsvorrichtung nach Anspruch 1, wobei die Trägerschicht flexibel ist und die Hochkonversionsvorrichtung auf den CIS laminiert ist.

## Revendications

1. Dispositif d'imagerie, comprenant un dispositif de conversion ascendante à infrarouge transparent, le dispositif de conversion ascendante à infrarouge transparent étant un empilement multicouche comprenant :
une couche d'anode ;
une couche de blocage de trous ;
une couche de sensibilisation à l'infrarouge ;
une couche de transport de trous ;
une couche électroluminescente ;
une couche de transport d'électrons ; et
une cathode, **caractérisé en ce que** la couche de sensibilisation à l'infrarouge comprend des points quantiques (QD) polydispersés présentant différents maxima d'absorption sur une plage de longueurs d'onde allant de moins de 1 à 2 µm, et **en ce que** le dispositif d'imagerie comprend en outre un capteur d'image CMOS (CIS).

2. Dispositif d'imagerie selon la revendication 1, dans lequel l'anode comprend de l'oxyde d'indium et d'étain (ITO), de l'oxyde d'indium et de zinc (IZO), de l'oxyde d'aluminium et d'étain (ATO), de l'oxyde d'aluminium et de zinc (AZO), des nanotubes de carbone ou des nanofils d'argent.

3. Dispositif d'imagerie selon la revendication 1, dans lequel la couche de blocage de trous comprend du TiO₂, du ZnO, du BCP, du Bphen, du 3TPYMB, ou du p-bis(triphénylsilyl)benzène (UGH2).

4. Dispositif d'imagerie selon la revendication 1, dans lequel la couche de sensibilisation à l'infrarouge comprend des QD de PbSe ou des QD de PbS.

5. Dispositif d'imagerie selon la revendication 1, dans lequel la couche de transport de trous comprend du 1,1-bis[(di-4-tolylamino)phényl]cyclohexane (TAPC), de la N,N'-diphényl-N,N'(2-naphthyl)-(1,1'-phényl)-4,4'-diamine (NPB) ou de la N,N'-diphényl-N,N'-di(m-tolyl) benzidine (TPD).

6. Dispositif d'imagerie selon la revendication 1, dans lequel la couche électroluminescente comprend du *tris*-(2-phénylpyridine) iridium (Ir(ppy)₃), du poly-[2-méthoxy, du 5-(2'-éthylhexyloxy) phénylène vinylène] (MEH-PPV), du tris-(8-hydroxy quinoléine) aluminium (Alq₃), ou de l'iridium (III) *bis*-[(4,6-di-fluorophényl)-pyridinate-N,C2']picolinate (Flrpic).

7. Dispositif d'imagerie selon la revendication 1, dans lequel la couche de transport d'électrons comprend du tris[3-(3-pyridyl)-mésityl] borane (3TPYMB), de la 2,9-diméthyl-4,7-diphényl-1,10-phénanthroline(BCP), de la 4,7-diphényl-1,10-phénanthroline (BPhen) ou du tris-(8-hydroxy quinoléine) aluminium (Alq₃).

8. Dispositif d'imagerie selon la revendication 1, dans lequel la cathode comprend de l'oxyde d'indium et d'étain (ITO), de l'oxyde d'indium et de zinc (IZO), de l'oxyde d'aluminium et d'étain (ATO), de l'oxyde d'aluminium et de zinc (AZO), un nanotube de carbone, un nanofil d'argent ou du Mg:Al.

9. Dispositif d'imagerie selon la revendication 1, dans lequel l'empilement multicouche comprend en outre une couche antireflet sur la cathode.

10. Dispositif d'imagerie selon la revendication 9, dans lequel la couche antireflet comprend une couche d'Alq₃ ayant une épaisseur inférieure à 200 nm.

11. Dispositif d'imagerie selon la revendication 1, dans lequel l'empilement multicouche comprend en outre une couche laissant passer la lumière infrarouge et bloquant la lumière visible située sur l'anode.

12. Dispositif d'imagerie selon la revendication 11, dans lequel la couche laissant passer la lumière infrarouge et bloquant la lumière visible comprend une pluralité de couches alternées de matériaux présentant des indices de réfraction différents.

13. Dispositif d'imagerie selon la revendication 12, dans lequel les couches alternées comprennent des couches de Ta₂O₅ et de SiO₂ ayant une épaisseur de 10 à 100 nm et la couche laissant passer la lumière infrarouge et bloquant la lumière visible comprend 2 à 80 couches.

14. Dispositif d'imagerie selon la revendication 1, dans lequel le CIS est le substrat de l'empilement multicouche.

15. Dispositif d'imagerie selon la revendication 1, dans lequel l'empilement multicouche comprend en outre une couche de support.

16. Dispositif d'imagerie selon la revendication 1, dans lequel la couche de support est rigide et le dispositif de conversion ascendante est couplé au CIS au moyen d'une fixation mécanique ou d'un adhésif.

17. Dispositif d'imagerie selon la revendication 1, dans lequel la couche de support est flexible et le dispositif de conversion ascendante est superposé au CIS.
